# EUROPEAN PATENT APPLICATION

(11) **EP 3 168 873 A1**
(43) Date of publication of application: **17.05.2017**
(21) Application number: 15194110.1
(22) Date of filing: 11.11.2015
(51) Int. Cl.: H01L 25/07, H01L 23/00, H01L 23/051

(54) **POWER SEMICONDUCTOR MODULE**

(71) Applicant: ABB Technology AG, 8050 Zürich (CH)
(72) Inventor: Cottet, Didier, 8050 Zürich (CH); Traub, Felix, 4310 Rheinfelden (CH)
(74) Representative: ABB Patent Attorneys

(57) **Abstract**

A power semiconductor module (10) comprises an electrical conducting base plate (14) and an electrically conducting top plate (35); a plurality of power semiconductor chips (12), which are arranged between the base plate (14) and the top plate (35) and which are attached with a collector face (16) to the base plate (14); a plurality of press elements (34), wherein each press element (34) is pressed by the top plate (35) with a foot (36) against an emitter area (18) on a power semiconductor chip (12) and wherein each press element (34) electrically connects the top plate (35) with the emitter area (18); at least two gate conductors (32) electrically insulated from the top plate (35), wherein each gate conductor (32) runs from the top plate (35) towards the base plate (14) and contacts at least one power semiconductor chip (12) in a gate area (24); and an electrically conducting emitter connection element (48), which is arranged between the base plate (14) and the top plate (35) and which electrically interconnects the feet (36) of the press elements (34).

## Description

### FIELD OF THE INVENTION

The invention relates to the field of packaging of power semiconductors. In particular, the invention relates to a power semiconductor module.

### BACKGROUND OF THE INVENTION

Power semiconductor modules, in particular for high voltage (HV) applications, such as HVDC (high voltage digital current), usually comprise a large number of paralleled semiconductor chips to meet the required current rating. To ensure high reliability and short-circuit withstand capability, an unequal distribution of stress to the paralleled semiconductor chips should be avoided.

For example, US 2014/0225245 A1 shows a power semiconductor module with a plurality of paralleled chips arranged on one base plate, which are contacted via press pins to a top plate.

### DESCRIPTION OF THE INVENTION

A reason for unequal current sharing between chips may be unbalanced inductive gate-circuit coupling coefficients between paralleled chips. Inductive coupling coefficients are very sensitive towards the design of the external busbars.

The inductive gate-circuit coupling coefficients are based on a loop between a press element for contacting the emitter of a semiconductor chip and a gate conductor for contacting a gate, which loop may have a comparable large surface area. This loop is traversed by the magnetic field produced by the currents in the power semiconductor module. The orientation of different loops with respect to the magnetic field and the flux through the loop surface area may be different for different semiconductor chips.

During switching, the changing magnetic field then induces voltages in a gate circuitry which are proportional to the magnetic fluxes through the corresponding gate-emitter loop.

Two solutions have been proposed to improve the current sharing between semiconductor chips in power semiconductor modules. Firstly, it may be possible to optimize the position of the press elements and the positions of semiconductor chips in the power semiconductor module, to minimize gate couplings after system integration. Secondly, the design of the busbar, which is electrically connected to the press elements, may be optimized in view of gate coupling imbalance and the resulting imbalance in current sharing. These optimizations are usually application specific. Usually, the high sensitivity of gate coupling coefficients towards an external busbar remains. Each new system application with a new busbar may have to be optimized individually.

It is an objective of the invention to provide a fast switching power semiconductor module that is reliable and has a high short-circuit withstand capability. It is a further objective of the invention to provide a power semiconductor module with balanced gate couplings.

This objective is achieved by the subject-matter of the independent claims. Further exemplary embodiments are evident from the dependent claims and the following description.

The invention relates to a power semiconductor module, which may comprise a plurality of parallel power semiconductor chips that are parallel-connected. The power semiconductor module may be stacked with other equally designed power semiconductor modules and/or may be employed in high power applications, in which voltages of more than 10 kV to 1000 kV are switched.

According to an embodiment of the invention, the power semiconductor module comprises an electrically conducting base plate and an electrically conducting top plate, a plurality of power semiconductor chips, which are arranged between the base plate and the top plate and which are attached with a collector face to the base plate, a plurality of press elements, wherein each press element is pressed by the top plate with a foot against an emitter area on a power semiconductor chip and wherein each press element electrically connects the top plate with the emitter area, one or more gate conductors electrically insulated from the top plate, wherein each gate conductor runs from the top plate towards the base plate and contacts at least one power semiconductor chip in a gate area, and an electrically conducting emitter connection element, which is arranged between the base plate and the top plate and which (directly) electrically interconnects the feet of the press elements.

The emitter potential of different semiconductor chips is not only distributed via the press elements and the top plate, but also via the emitter connection element, which already electrically interconnects the emitters nearly directly at the emitter areas, i.e. at feet of the press elements. The emitter press elements are paralleled by an additional conducting structure at the lowest possible level, which may be as close to the semiconductor chips as possible.

In such a way, the loop formed between the gate conductors and the emitter current path depends less on the position of the gate conductor inside the semiconductor module and the gate coupling becomes more uniform. Additionally, the dependence of gate-circuit couplings of the power semiconductor module on the design of an external system may be reduced.

The power semiconductor chips may provide power semiconductor switches with a collector, emitter and a gate. For example, the power semiconductor switches may be IGBTs and/or reverse conducting IGBTs. Furthermore, it may be possible that some of the semiconductor chips are diodes, which, however, do not have gates and gate areas, respectively, but which also may be contacted via press elements.

The top plate may be a part and/or may be electrically connected to a busbar. It also may be possible that the top plate is connected to a base plate of a further power semiconductor module, i.e. several equally designed power semiconductor modules may be stacked.

According to an embodiment of the invention, each press element comprises a spring arrangement for pressing the foot of the press element in direction and/or against the semiconductor chip, which spring arrangement is pressed against the emitter connection element. In other words, the emitter connection element, which may be a substantially flat electrically conducting structure, may contact the press element with a part that is not pressed against the semiconductor chip. The spring arrangement may press the foot to one or more conducting plates on top of the semiconductor chip. The electrically conducting emitter connection element may be arranged between the foot and the one or more conducting plates.

It has to be understood that a flat structure may be locally flat and need not be only two-dimensional. For example, a specially formed metal plate also may be a flat structure.

According to an embodiment of the invention, the spring arrangement comprises a bracket surrounding a spring, which bracket may have a higher conductivity than the spring and which bracket is pressed against the emitter connection element. For example, the emitter connection element may be provided at a position, such that the bracket may be pressed against the emitter contact element, wherein the foot of the press element reaches through the emitter connection element and is pressed against the emitter area.

According to an embodiment of the invention, the emitter connection element comprises a flat electrically conducting structure, for example a metal plate and/or metal foil, which is in contact with the spring arrangements, wherein the feet of the press elements reach through the flat electrically conducting structure. For example, the flat electrically conducting structure may be a metal plate and/or metal foil with openings above the emitter areas. These openings may be as large that the foot of the press element may run through an opening, while the spring arrangement (for example a bracket of the spring arrangement) may contact the rim of the opening.

According to an embodiment of the invention, the emitter connection element is attached to the spring arrangements of the press elements. For example, the emitter connection element may be fixed (soldered, glued, etc.) to the spring arrangement, before the power semiconductor module is assembled.

According to an embodiment of the invention, the emitter connection element is arranged on a plastics frame, which plastics frame is arranged between the base plate and the top plate and which plastics frame comprises openings, through which the feet of the press elements reach. A base plate part of the power semiconductor module may comprise a plastics frame, which partially covers the base plate and the power semiconductor chips arranged thereon. The plastics frame also may have openings above the emitter areas for receiving the feet of the press elements. The emitter contact element may be arranged between this plastics frame and the spring arrangements, i.e. the spring arrangements may press the emitter contact element against the plastics frame.

According to an embodiment of the invention, the emitter connection element comprises a flat, electrically conducting structure, which is arranged between the feet of the press elements and the emitter areas. Additionally or alternatively, the emitter contact element may have an electrically conducting structure, which is sandwiched between the feet and the emitter areas.

According to an embodiment of the invention, the flat electrically conducting structure comprises pads, each pad interpositioned between a foot of a press element and an emitter area. For example, the pads may be metal plates, which may be interconnected with electrically conducting ribbons or with other flexible, electrically conducting means, such as wires. For example, the ribbons may be provided by a metal foil, which is attached to the plates.

According to an embodiment of the invention, the pads are lattice-like interconnected via the ribbons. In other words, one pad may be interconnected with all neighbouring pads via flexible electrically conduction means.

According to an embodiment of the invention, the ribbons pass above a plastics frame with openings through which the feet of the press elements pass. As mentioned above, the base plate part of the semiconductor module may have a plastics frame partially covering the power semiconductor chips, where openings are provided above the emitter areas. It may be possible that before the assembly of the module, the pads of the emitter connection element are positioned above the openings. During the assembly, the feet of the press elements push the pads onto the emitter areas, while the ribbons of the emitter connection elements stay outside the plastics frame. In the end, the ribbons may run above parts of the plastics frame between the openings.

According to an embodiment of the invention, a gate conductor comprises a gate conductor spring, which is pressed against a base plate gate runner, which is electrically insulated attached to the base plate. The base plate gate runner may be provided by a conducting area on the base plate. There also may be top plate gate runners, which may be provided by a conducting area on the top plate.

The top plate gate runners may be electrically insulated from but may be arranged close to the top plate and/or the base plate gate runners may be electrically insulated from but may be arranged close to the base plate. The top plate gate runners may also provide an external gate contact for the module (e.g., at the side or on the top of the top plate). The bottom plate gate runners may have a connection by wire bonds to the semiconductor gate areas. The top plate gate runners and the base plate gate runners may be connected by the gate conductor spring.

In general, the gates and gate areas, respectively, of semiconductor chips, which are arranged at the side of the base plate, may be electrically connected with one or more gate conductors, which enter the power semiconductor module at the side of the top plate. For example, a gate conductor may enter the power semiconductor module through a hole in the top plate or from the side. As one possibility, the gate conductor may comprise a gate conductor spring, which is connected to the top plate and which is pressed (similarly to the press elements for the emitters) against a gate runner that is provided on the base plate.

The gate conductor also may comprise a gate pin for contacting the gate area on the semiconductor chip and/or the gate runner on the base plate.

According to an embodiment of the invention, the gate areas of at least two power semiconductor chips are electrically connected via bond wires with the gate runner of a gate conductor. In such a way, two or more (for example four) power semiconductor chips may be gate-connected via one gate conductor.

According to an embodiment of the invention, each press element comprises a pin attached to the foot of the press element, which pin is guided in the top plate and which supports a spring arrangement of the press element. For stabilizing the spring arrangement, which may comprise a plurality of stacked flat springs, a pin may be guided in a hole in the top plate.

According to an embodiment of the invention, the emitter area comprises at least one of a first metal layer (such as a Molybdenum layer) and a second metal layer (such as an Aluminium layer) provided on the power semiconductor chip. Such layers may improve the fail safety and the thermal behaviour of the module.

These and other aspects of the invention will be apparent from and elucidated with reference to the embodiments described hereinafter.

### BRIEF DESCRIPTION OF THE DRAWINGS

The subject-matter of the invention will be explained in more detail in the following text with reference to exemplary embodiments which are illustrated in the attached drawings.
Fig. 1 schematically shows a top view of parts of a power semiconductor module according to an embodiment of the invention.
Fig. 2 schematically shows a sectional view of a power semiconductor module according to an embodiment of the invention.
Fig. 3 schematically shows a perspective view of parts of a power semiconductor module according to an embodiment of the invention.
Fig. 4 schematically shows a sectional view of a power semiconductor module according to an embodiment of the invention.
Fig. 5 schematically shows a perspective view of a conduction structure for a power semiconductor module according to an embodiment of the invention.
Fig. 6 shows a diagram with gate-circuit coupling inductivities of a power semiconductor module according to an embodiment of the invention.

The reference symbols used in the drawings, and their meanings, are listed in summary form in the list of reference symbols. In principle, identical parts are provided with the same reference symbols in the figures.

### DETAILED DESCRIPTION OF EXEMPLARY EMBODIMENTS

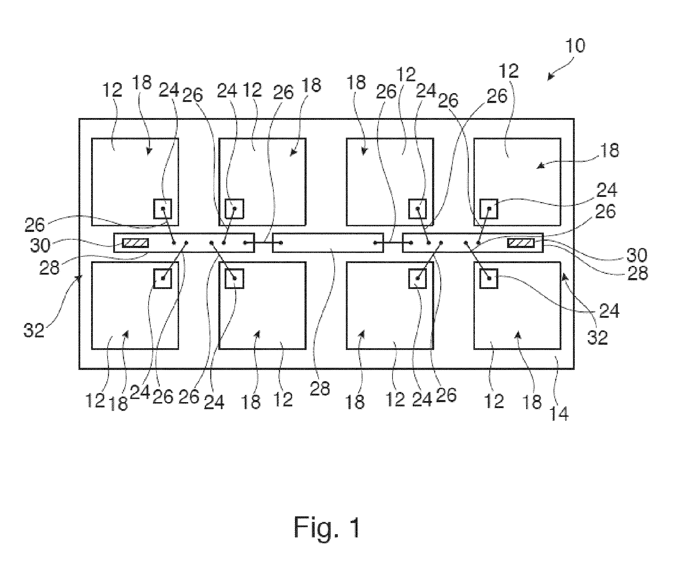

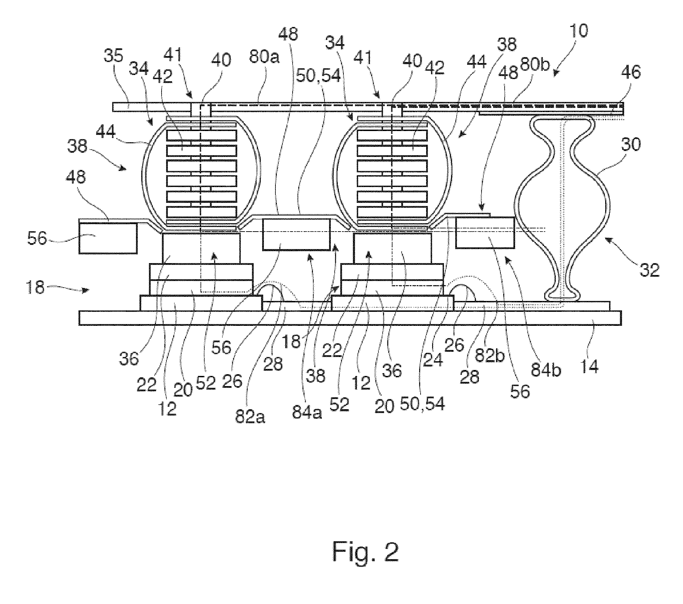

Fig. 1 shows a top view onto the base part of a power semiconductor module 10, which comprises eight power semiconductor chips 12, which are arranged in two rows on a base plate 14. Fig. 2 shows a cross section through power semiconductor module 10, where it also can be seen that the semiconductor chips 12 are attached (such as soldered or sintered) with a collector face 16 to the base plate 14. Opposite to the collector face 16, the semiconductor chips 12 provide an emitter area 18, which is covered by a first metal layer 20 (which may be an Aluminium layer) and a second metal layer 22 (which may be a Molybdenum layer), and a gate area 24 (see Fig. 1). In general, there may one, two or more metal layers 20, 22, which may be made of metal and/or an alloy.

The gate areas 24 are electrically connected via wire bonds 26 to a gate runner 28, which are furthermore contacted by gate conductor springs 30. In the design shown in Fig. 1, the gate areas 24 of four semiconductor chips 12 are connected to a gate runner 28, which is contacted by a gate conductor spring 30. Each of the two gate runners 28, which are arranged between the two rows of semiconductor chips 12, is contacted by a gate conductor spring 30. The two gate runners 28 are interconnected via a third gate runner 28, which is connected via wire bonds 26 with the two gate runners 28.

The wire bonds 26, gate runners 28 and the gate conductor springs 30 form a gate conductor 32, which interconnects the gate areas 24 of the semiconductor chips 12 with the outside of the power semiconductor module 10.

Returning to Fig. 2, the emitter areas 18 of the semiconductor chips 12 are contacted via press elements 34 with an electrically conducting top plate 35 of the power semiconductor module 10, which is arranged in parallel to the base plate 14. Each press element 34 comprises a foot 36, which is pressed against the emitter area 18 via a spring arrangement 38. The foot 36 is attached to a pin 40 inside the spring arrangement 38, which is also guided in a hole 41 in the top plate 35. The spring arrangement 38 comprises a plurality of disc springs 42, which are guided by the pin 40 and a bracket 44 surrounding the springs 42 and the pin 40. The bracket 44 is used for enhancing the conductivity of the spring arrangement 38, and, for example, may be made of copper and/or may have a higher conductivity as the disc springs 42.

It may be possible that the foot 36 is pressed against the one or more metal layers 20, 22 or that the foot 36 is pressed directly against the chip 12.

Two or more of the power semiconductor modules 10 may be stacked by placing the base plate 14 of the one power semiconductor module 10 onto the top plate 35 of the next power semiconductor modules 10. For example, a switch system for high voltage applications and/or a half-bridge may be assembled.

Fig. 2 shows a gate conductor spring 30, which contacts a top plate gate runner 46, which runs electrically isolated from the top plate 35 on the inner side of the top plate 35 to the outside of the power semiconductor module 10. Alternatively, the gate conductor springs 30 may protrude through holes in the top plate 35 to the outside.

For each power semiconductor chip 12, the corresponding press element 34 and the top plate 35 together with the gate conductors 32 (i.e. elements 26, 28, 30, 46) form a first (unrestricted) emitter-gate current path 80a and a second (unrestricted) emitter-gate current path 80b. The (unrestricted) emitter-gate current paths 80a, 80b are sensitive to electromagnetic fields inside the power semiconductor module 10. Due to the arrangement of the power semiconductor chips 12 and the other elements inside the power semiconductor module 10, the gate-emitter paths 80a, 80b of different power semiconductor chips 12 may be exposed to different electromagnetic fields and/or may have different inductivity. The different gate-circuit coupling inductivities caused by the different and/or gate-emitter paths 84a, 84b influence the switching behaviour of the power semiconductor chips 12, since they induce different voltages into the nominal gate voltage and therefore retard or accelerate the switching times.

To better balance the gate-circuit coupling inductivities, the power semiconductor module 10 comprises an electrically conducting emitter connection element 48, which is arranged between the base plate 14 and the top plate 35 and which electrically interconnects the feet 36 of the press elements 34. The emitter connection element 48 may distribute a different electrical potential between the feet 36 and therefore may homogenise the gate-circuit coupling of the different power semiconductor chips.

In particular, due to the emitter connection element 48, (restricted) gate-emitter current paths 82a, 82b are formed. The gate-emitter current paths 82a, 82b are formed from the the emitter connection element 48 together with the gate conductors 32. Therefore, coupling areas 84a, 84b of the gate-emitter current paths 82a, 82b coupling with electromagnetic fields may be reduced by the emitter connection element 48. Thus, gate-circuit coupling inductivities, which are based on the coupling areas 84a, 84b may be reduced with respect to the unrestricted gate-emitter current paths.

The emitter connection element 48 comprises a flat electrically conducting structure 50, which is in contact with the spring arrangements 38 and in particular the brackets 44, wherein the feet 36 of the press elements 34 reach through openings 52 of the flat electrically conducting structure 50.

When the press element 34 is pressed against the semiconductor chip 12, the bracket 44 of the press element 34 may be pressed against the rims of the openings 52.

For example, the flat electrically conducting structure 50 may be a sufficiently flexible, patterned, metal plate 54, which may be placed on a plastics frame 56, which is attached to the base plate 14 and which partially covers the power semiconductor chips 12. The plastics frame 56 also may have openings 58 and may be similarly patterned as the metal plate 54. Furthermore, the metal plate 54 may be attached to the plastics frame 56. For example, the metal plate 54 may be glued to the top of the plastics frame 56.

When the feet 36 of the press elements 34 are inserted into the plastics frame 56 and pressure is exerted, the press elements 34 and in particular their brackets 44 may contact the metal plate 54.

A weak electrical contact between the press elements 34 and the metal plate 54 (in general the conducting structure 50) may be tolerated since the conducting structure 50 does not have to support a large current. However, the electrical connection may be improved using an electrically conductive glue.

The flexibility of the metal plate 54 may have to be adjusted in a way to provide the electrical contact to the press element 34 while not reducing the contact pressure needed to establish a short-circuit failure mode (in which the first metal layer 20 and the second metal layer 22 may melt).

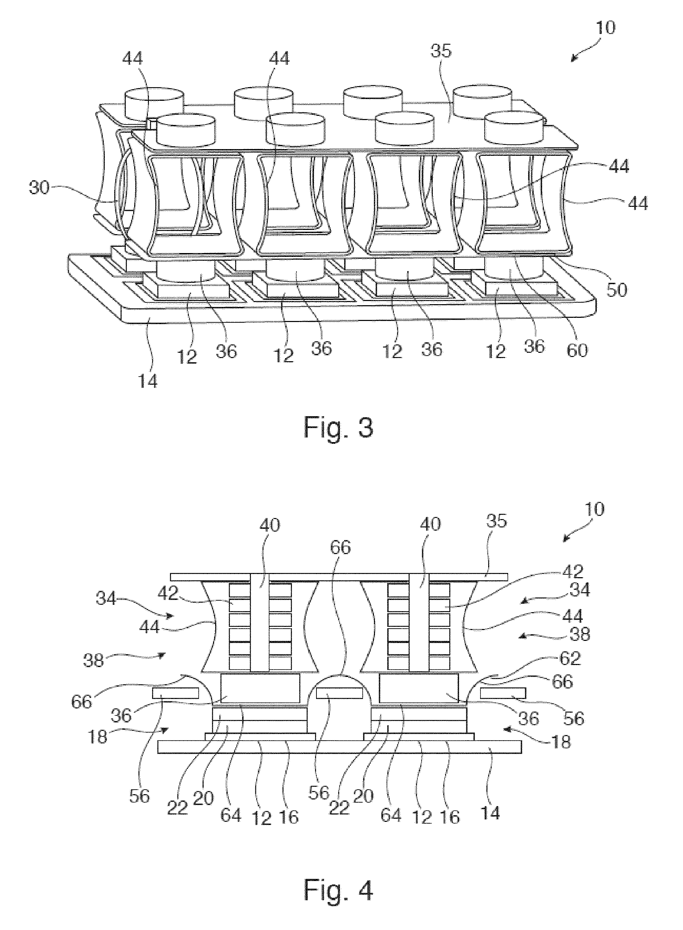

Fig. 3 shows elements of a further embodiment of a power semiconductor module 10. For example, in Fig. 3, the pins 40, springs 42 and the plastics frame 56 are not shown. In Fig. 3, the conducting structure 50 is realized as a conducting foil 60 or flexible metal plate 54, which is attached to the bottom of the spring arrangements 38 and in particular to the bottom of the brackets 44.

Fig. 4 shows a further embodiment of a power semiconductor module 10, in which the emitter connection element 48 comprises a flat electrically conducting structure 62, which is arranged between the feet 36 of the press elements 34 and the emitter areas 18. It has to be understood that the flat electrically conducting structure 62 may be combined with the flat electrically conducting structure 50 of Fig. 2 and/or Fig. 3.

The emitter connection element 48 may be arranged between the foot 36 and the chip 12 and optionally there may be at least one metal layer 20, 22 between the foot 36 and the chip 12. The at least one metal layer 20, 22 may be arranged between the emitter connection element 48 and chip 12.

The electrically conducting structure 62 is arranged between the feet 36 of the press elements 34 and the emitter areas 18 and in particular is sandwiched between the feet 36 and the second metal layer 22.

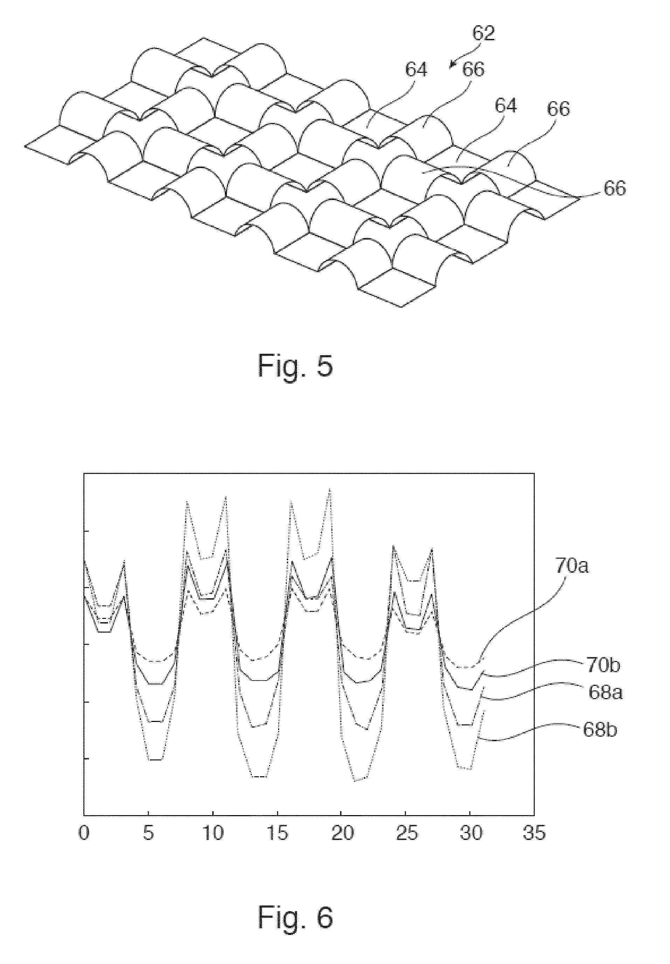

As also shown in Fig. 5, the flat electrically conducting structure 62 comprises pads 64, wherein each pad 64 is interpositioned between a foot 36 of a press element 34 and an emitter area 18. The pads 64 may be chip-sized. The pads 64 may be thin (compared to the thickness of the chip 12) and/or may be semi-rigid. The pads 64 may be rigid enough to keep its shape but may be flexible enough to allow flexibility not to reduce the pressure of the press element 34 on the semiconductor chip 12.

The pads 64 may be lattice-like interconnected with electrically conducting ribbons 66, which, for example, may be made of a metal foil. It may be possible that also the pads 64 are made of metal foil. The flat electrically conducting structure 62 may be made one-piece.

Before the press elements 34 are inserted into the openings 58 in the plastics frame 56, the flat electrically conducting structure 62 may be placed in the openings 58 (i.e. the pads 64) and on the plastics frame 56. When the feet 36 of the press elements 34 press on the pads 64 and on the emitter area 18, the ribbons 66 pass above the plastics frame 56.

Fig. 6 shows a diagram with gate-circuit coupling inductivities of four different power semiconductor modules 10. These inductivities may be seen as gate-circuit coupling coefficients indicating the balance of the gate circuit with respect to different paralleled power semiconductor chips 12.

Each of the power semiconductor modules 10 comprises 32 power semiconductor chips 12, which numbers are listed from the left to the right. On the y-axis, the diagram shows the corresponding gate-circuit coupling inductivities.

The dotted curves 68a, 68b relate to power semiconductor modules 10 without an emitter connection element 48, whereas the continuous curves 70a, 70b relate to power semiconductor modules 10 with an emitter connection element 48.

The curves 68a, 70a relate to a power semiconductor module 10 used as the high side of a half-bridge and the curves 68, 70b relate to a power semiconductor module 10 used as the low side of a half-bridge.

In both cases it can be seen that the gate-circuit coupling inductivities of the power semiconductor module 10 with an emitter connection element 48 is more balanced (curves 70a, 70b).

While the invention has been illustrated and described in detail in the drawings and foregoing description, such illustration and description are to be considered illustrative or exemplary and not restrictive; the invention is not limited to the disclosed embodiments. Other variations to the disclosed embodiments can be understood and effected by those skilled in the art and practising the claimed invention, from a study of the drawings, the disclosure, and the appended claims. In the claims, the word "comprising" does not exclude other elements or steps, and the indefinite article "a" or "an" does not exclude a plurality. A single processor or controller or other unit may fulfil the functions of several items recited in the claims. The mere fact that certain measures are recited in mutually different dependent claims does not indicate that a combination of these measures cannot be used to advantage. Any reference signs in the claims should not be construed as limiting the scope.

### LIST OF REFERENCE SYMBOLS

- 10: power semiconductor modules
- 12: power semiconductor chip
- 14: base plate
- 16: collector face
- 18: emitter area
- 20: first metal layer
- 22: second metal layer
- 24: gate area
- 26: wire bond
- 28: base plate gate runner
- 30: gate conductor spring
- 32: gate conductor
- 34: press element
- 35: top plate
- 36: foot
- 38: spring arrangement
- 40: pin
- 41: hole in top plate
- 42: disc spring
- 44: bracket
- 46: top plate gate runner
- 48: emitter connection element
- 50: conducting structure
- 52: openings
- 54: metal plate
- 56: plastics frame
- 58: openings
- 60: metal foil
- 62: conducting structure
- 64: pad
- 66: ribbon
- 68a: gate-circuit coupling inductivities for module without emitter connection element
- 68b: gate-circuit coupling inductivities for module without emitter connection element
- 70a: gate-circuit coupling inductivities for module with emitter connection element
- 70b: gate-circuit coupling inductivities for module with emitter connection element
- 80a: first unrestricted emitter-gate current path
- 80b: second unrestricted emitter-gate current path
- 82a: first emitter-gate current path
- 82b: second emitter-gate current path
- 84a: first coupling area
- 84b: second coupling area

## Claims

1. A power semiconductor module (10), comprising:
an electrical conducting base plate (14) and an electrically conducting top plate (35); a plurality of power semiconductor chips (12), which are arranged between the base plate (14) and the top plate (35) and which are attached with a collector face (16) to the base plate (14);
a plurality of press elements (34), wherein each press element (34) is pressed by the top plate (35) with a foot (36) against an emitter area (18) on a power semiconductor chip (12) and wherein each press element (34) electrically connects the top plate (35) with the emitter area (18);
at least one gate conductor (32) electrically insulated from the top plate (35), wherein the gate conductor (32) runs from the top plate (35) towards the base plate (14) and contacts at least one power semiconductor chip (12) in a gate area (24);
an electrically conducting emitter connection element (48), which is arranged between the base plate (14) and the top plate (35) and which electrically interconnects the feet (36) of the press elements (34).

2. The power semiconductor module (10) of claim 1,
wherein each press element (34) comprises a spring arrangement (38) for pressing the foot (36) of the press element (34) in direction of the semiconductor chip (12), which spring arrangement (38) is pressed against the emitter connection element (48).

3. The power semiconductor module (10) of claim 2,
wherein the spring arrangement (38) comprises a bracket (44) surrounding a spring (42), which bracket (44) has a higher conductivity than the spring (42) and which bracket (44) is pressed against the emitter connection element (48).

4. The power semiconductor module (10) of claim 2 or 3,
wherein the emitter connection element (48) comprises a flat electrically conducting structure (50), which is in contact with the spring arrangements (38), wherein the feet (36) of the press elements (34) reach through the flat electrically conducting structure (50).

5. The power semiconductor module (10) of claim 4,
wherein the flat electrically conducting structure (50) comprises a metal plate (54) and/or metal foil (60).

6. The power semiconductor module (10) of one of claims 2 to 5,
wherein the emitter connection element (48) is attached to the spring arrangements (38) of the press elements (34).

7. The power semiconductor module (10) of one of the preceding claims,
wherein the emitter connection element (48) is arranged on a plastics frame (56), which plastics frame (56) is arranged between the base plate (14) and the top plate (35) and which plastics frame (56) comprises openings (58), through which the feet (36) of the press elements (34) reach.

8. The power semiconductor module (10) of one of the preceding claims,
wherein the emitter connection element (48) comprises a flat electrically conducting structure (62), which is arranged between the feet (36) of the press elements (34) and the emitter areas (18).

9. The power semiconductor module (10) of claim 8,
wherein the flat electrically conducting structure (62) comprises pads (64), wherein each pad (64) is interpositioned between a foot (38) of a press element (34) and an emitter area (18).

10. The power semiconductor module (10) of claim 9,
wherein the pads (64) are interconnected with electrically conducting ribbons (66).

11. The power semiconductor module (10) of claim 10,
wherein the pads (64) are lattice-like interconnected via the ribbons (66).

12. The power semiconductor module (10) of claim 10 or 11,
wherein the ribbons (66) pass above a plastics frame (56) with openings (58) through which the feet (36) of the press elements (34) pass.

13. The power semiconductor module (10) of one of the preceding claims,
wherein a gate conductor (32) comprises a gate conductor spring (30), which is pressed against a gate runner (28), which is electrically insulated attached to the base plate (14); and/or
wherein a gate area (24) of a power semiconductor chips (12) is electrically connected via bond wires (26) with the gate runner (28) of a gate conductor (32).

14. The power semiconductor module (10) of one of the preceding claims,
wherein each press element (34) comprises a pin (40) attached to the foot (36) of the press element (34), which pin (40) is guided in the top plate (35) and which supports a spring arrangement (38) of the press element (34).

15. The power semiconductor module (10) of one of the preceding claims,
wherein the emitter area (18) comprises at least one metal layer (20, 22) provided on the power semiconductor chip (12).
